# EUROPÄISCHE PATENTSCHRIFT

(11) **EP 3 504 947 B1**
(45) Veröffentlichungstag und Bekanntmachung des Hinweises auf die Patenterteilung: **31.03.2021**
(21) Anmeldenummer: 17754596.9
(22) Anmeldetag: 10.08.2017
(51) Int. Cl.: H05K 7/14, B25H 7/00

(54) **MONTAGEHILFE**
MOUNTING AID
DISPOSITIF D'AIDE AU MONTAGE

(30) Priorität: 23.08.2016 AT 3912016
(43) Veröffentlichungstag der Anmeldung: 03.07.2019
(73) Patentinhaber: Patchbox GmbH, 1170 Wien (AT)
(72) Erfinder: GENG, Alexander, 1090 Wien (AT); HOFSTÄTTER, Josef, 3376 Ennsbach (AT)
(74) Vertreter: Keschmann, Marc
(86) Internationale Anmeldenummer: PCT/AT2017/000057
(87) Internationale Veröffentlichungsnummer: WO 2018/035546

(56) Entgegenhaltungen:
- US-A1- 2003 150 823
- US-A1- 2006 157 436
- US-A1- 2009 026 898
- US-A1- 2012 120 611
- US-A1- 2015 282 377

## Beschreibung

Die Erfindung betrifft eine Montagehilfe für die Montage von Einschubelementen in Rahmengestellen, insbesondere Racks für die Verwendung in der Informationstechnik.

Die Erfindung betrifft weiters die Verwendung einer derartigen Montagehilfe.

Montagehilfen für die Montage von Einschubelementen in Rahmengestellen mit zwei relativ zueinander verstellbaren Schenkeln sind in den Dokumenten US 2012/120611 A1 und US 2015/282377 A1 offenbart.

Unter dem Begriff Rack ist im Zusammenhang mit der vorliegenden Erfindung und entsprechend dem fachlichen Sprachgebrauch ein Gestell für Elektrogeräte mit einer genormten Breite von z.B. 19 Zoll zu verstehen, bei dem die einzelnen Geräte, d.h. die Einschubelemente, die sich im Rack montieren lassen, eine der genormten Breite entsprechende Breite von z.B. 19 Zoll aufweisen. In Höhenrichtung wird ein Rack in genormte Höheneinheiten unterteilt, womit die Mindesthöhe eines zu montierenden Einschubelements festgelegt wird. Einschubelemente haben demgemäß eine standardisierte Höhe von einer Höheneinheit oder einem Vielfachen davon. Eine Höheneinheit (HE) eines Standard 19 Zoll Racks besitzt eine Höhe von 1,75 Zoll.

Befestigt werden die Einschubelemente mit ihrer seitlich vorstehenden Frontplatte an den Lochreihen (quadratische oder runde Löcher) senkrecht an der Vorderseite des Rahmengestells verlaufender Blechwinkel. Die Frontplatte ist in ihren seitlich vorstehenden Bereichen mit Löchern versehen, die in einer mit der Lochreihe der Blechwinkel fluchtenden Position der Aufnahme von Verbindungsmitteln, insbesondere Schraubbolzen dienen. Die Blechwinkel können etwa 2mm stark sein und sind im Falle genormter 19 Zoll Racks je 15,88mm breit und bilden zwischen sich eine etwa 19 Zoll breite Öffnung aus. Pro Höheneinheit liegen drei Löcher in Abständen von jeweils 0,655 Zoll übereinander.

Die Montage von Einschubelementen in Rahmengestellen ist aufwendig und gestaltet sich meist schwierig, da die Einschubelemente ein gewisses Gewicht sowie eine gewisse Sperrigkeit aufweisen. Die Montage von Einschubelementen erfolgt meist an der Vorderseite des Rahmengestells, also dort, wo die mit der Lochreihe versehenen senkrecht verlaufenden Blechwinkel angeordnet sind. Da Rahmengestelle der herkömmlichen Art keine Auflagefläche zum Aufsetzen des Einschubelements bieten, muss der Monteur das Einschubelement händisch in eine Position bringen, in der die Löcher an den seitlich vorstehenden Bereichen der Frontplatte mit den Löchern der Lochreihe der Blechwinkel fluchten, das Einschubelement in dieser Position halten und die Verbindungsschrauben anbringen. Dabei muss der Monteur das Einschubelement entweder selbst in der korrekten Position halten, sodass zur Befestigung des Einschubelements nur eine freie Hand zur Verfügung steht, oder die Montage muss zu zweit durchgeführt werden, wobei einer der Beteiligten das Einschubelement in der korrekten Montageposition halten muss und der andere parallel dazu die Montage vornimmt.

Alternativ kann die Montage von Einschubelementen auch an der ebenfalls mit einer Lochreihe versehenen Rückseite des Rahmengestells erfolgen.

Auf Grund der oben genannten Unzulänglichkeiten ist die Montage von Einschubelementen zeitlich aufwändig und mit einem hohen Personalaufwand verbunden.

Die vorliegende Erfindung zielt daher darauf ab, eine Montagehilfe bereitzustellen, mit welcher die vorgenannten Nachteile überwunden werden können.

Zur Lösung dieser Aufgabe sieht die Erfindung eine Montagehilfe vor, die zumindest zwei relativ zueinander verstellbare, insbesondere verschwenkbare Schenkel umfasst, wobei die Schenkel an ihren freien Enden jeweils ein zum Schenkel abgewinkelt angeordnetes Befestigungselement aufweisen, wobei die Befestigungselemente zum Befestigen der freien Enden der Schenkel an zueinander gerichteten, nach innen ragenden und mit einer Lochreihe versehenen Schienen, insbesondere Blechwinkeln des Rahmengestells ausgebildet sind. Die erfindungsgemäße Montagehilfe ermöglicht einen werkzeuglosen, raschen Einbau von Einschubelementen in Rahmengestellen, welcher für eine einzelne Person ohne erheblichen Kraftaufwand und zeitsparend zu bewerkstelligen ist.

Vor der Montage wird die Montagehilfe an der gewünschten Position, d.h. unmittelbar unterhalb der gewünschten Montagehöhe des Einschubelements, von vorne in das Rack eingeführt. Anschließend werden die Schenkel relativ zueinander verschwenkt bis die an den Enden der Schenkel abgewinkelt angeordneten Befestigungselemente an den Schienen, insbesondere Blechwinkeln des Racks zu liegen kommen und in der Folge dort befestigt werden können. Die Oberkante der Schenkel bildet so eine Auflagefläche für das einzubauende Einschubelement. Das Einschubelement kann bei der Montage auf der Oberkante der Schenkel abgesetzt werden, sodass der Monteur das Einschubelement für die Befestigung an den Schienen, insbesondere Blechwinkeln nicht mehr halten muss.

Die Montaghilfe ist im befestigten Zustand vorzugsweise lediglich mit den genannten Befestigungselementen am Rahmengestell gehalten, wobei die Schenkel von den Schienen bzw. Blechwinkeln ausgehend in das Innere des Rahmengestells nach hinten ragen und im in das Innere ragenden Bereich keine weitere Unterstützung haben. Um die Montagehilfe möglichst verwindungssteif auszubilden, ist hierbei bevorzugt vorgesehen, dass die Schenkel als flache, plattenförmige Schenkel ausgebildet sind. Die plattenförmigen Schenkel weisen bevorzugt eine in Längsrichtung verlaufende Verstärkungsrippe auf, wodurch die Biegesteifigkeit erhöht wird.

Die Erfindung ist jedoch nicht nur als Montagehilfe für den Einbau in mit Blechwinkeln versehene Rahmengestelle geeignet. Alternativ wäre beispielsweise auch die Montage von Einschubelementen an mit einer Lochreihe versehenen Schienen oder Blechprofilen denkbar. Solche Blechprofile können z.B. in die Wand eingegipst und müssen dementsprechend nicht winkelförmig ausgebildet sein.

Bevorzugt ist die Montagehilfe derart ausgebildet, dass die Schenkel zwischen einer aneinanderliegenden Aufbewahrungsposition und einer V-förmig auseinandergeklappten Montageposition verschwenkbar sind.

Die aneinanderliegende Aufbewahrungsposition, d.h. jene Position, in welcher die beiden Schenkel plan aneinander liegen, ermöglicht eine platzsparende Verstauung der Montagehilfe in z.B. einem Werkzeugkoffer. In der V-förmig auseinander geklappten Montageposition wiederum spannt die Montagehilfe ein Dreieck auf, was eine stabile Abstützung des Einschubelements gewährleistet.

Weiters ist bevorzugt vorgesehen, dass das abgewinkelt ausgebildete Befestigungselement einen Spalt aufweist, in welchem die mit der Lochreihe versehene Schiene des Rahmengestells aufnehmbar ist. Das Eigengewicht der Schenkel übt dabei ein Kippmoment auf die Befestigungselemente aus, was bei geeigneter Auslegung zu einem Verkeilen der Befestigungselemente an der im Spalt der Befestigungselemente jeweils aufgenommene Schiene und zu einer Selbsthemmung führt, sodass die Montagehilfe auch ohne weitere Verbindungselemente an den Schienen hält. Dieser Effekt wird beim Auflegen eines Einschubelements noch weiter verstärkt.

Besonders bevorzugt wird der Spalt durch zwei parallele Platten gebildet, sodass die Schienen, insbesondere Blechwinkel des Racks zwischen den beiden Platten aufgenommen werden. Die Ausführung mit zwei den Spalt begrenzenden Platten ermöglicht eine zusätzliche Befestigung der Befestigungselemente an den Schienen bzw. Blechwinkeln. Gemäß einer ersten bevorzugten Weiterbildung ist zu diesem Zweck vorgesehen, dass die Platten in verstellbarem Abstand voneinander gehalten sind und mit Hilfe von Spannmitteln unter Einklemmung der Schiene bzw. des Blechwinkels zusammenspannbar sind. Der verstellbare Abstand der Platten ermöglicht eine einfache Anpassung der Spaltbreite an die herstellerabhängig variierende Stärke der Schienen, insbesondere Blechwinkel.

Der verstellbare Abstand erleichtert auch das Zusammenspannen der Platten unter Einklemmung der Schienen. Beim Platzieren des Montageelements im Rack ist ein etwas breiterer Abstand der beiden Platten vorteilhaft. Befindet sich das Montageelement bereits an der korrekten Position, wird dieses fixiert, was im vorgenannten Fall mittels Spannmitteln, welche den Abstand zwischen den Platten verringern und so ein Einklemmen des Blechwinkels bedingen, geschieht.

Besonders bevorzugt sind die Spannmittel Schrauben.

Gemäß einer alternativen Ausbildung ist bevorzugt vorgesehen, dass eine erste der beiden Platten starr mit dem jeweiligen Schenkel verbunden ist und wenigstens ein, vorzugsweise zwei, durch ein Loch der Lochreihe steckbare(s) Verbindungselement(e) trägt, und dass eine zweite der beiden Platten vom Verbindungselement hintergriffen werdend einschiebbar angeordnet ist.

Die an der ersten Platte angeordneten Verbindungselemente werden in der gewünschten Höhe von hinten oder vorne durch die jeweiligen Löcher der Schiene bzw. des Blechwinkels des Racks gesteckt. Um die Montagehilfe zu fixieren, wird die zweite Platte auf der anderen Seite, d.h. unter Aufnahme der Schiene bzw. des Blechwinkels zwischen den beiden Platten, so positioniert, dass die Verbindungselemente die zweite Platte hintergreifen, wodurch die Verbindungselemente gegen ein Heraustreten aus dem jeweiligen Loch gesichert und die Befestigungselemente dadurch relativ zur Schiene bzw. zum Blechwinkel fixiert werden. Die Verbindungselemente weisen zu diesem Zweck bevorzugt einen Vorsprung, wie z.B. ein verdicktes Ende auf, welches den Rand einer in der zweiten Platte ausgebildeten Öffnung hintergreift.

Besonders bevorzugt ist die zweite Platte relativ zur ersten Platte, vorzugsweise an dieser, verschiebbar geführt, sodass die zweite Platte in einfacher Weise in diejenige Position verschoben werden kann, in der die Verbindungselemente die zweite Platte hintergreifen. Die Relativverschieblichkeit der zweiten Platte wird in konstruktiv besonders einfacher Weise vorzugsweise dadurch erreicht, dass an einer der Platten angeordnete Stifte oder Bolzen in an der anderen Platte ausgebildeten Langlöchern verschieblich gehalten sind.

Bevorzugt weist die zweite Platte wenigstens einen randseitig offenen Schlitz auf, dessen Ränder in der zur Lochreihe hin verschobenen Position der zweiten Platte von einem verbreiterten Ende des Verbindungselements, insbesondere Stifts, hintergriffen sind.

Eine bevorzugte Ausbildung der Erfindung sieht vor, dass die Schenkel um eine parallel zur Längserstreckung der Schienen, insbesondere Blechwinkel verlaufende Schwenkachse relativ zueinander verschwenkbar sind.

Erfindungsgemäß ist vorgesehen, dass die Schenkel durch ein die Schwenkachse aufweisendes Gelenk unmittelbar miteinander verbunden sind, sodass die Schenkel in der auseinandergeklappten Montageposition eine V-Form ausbilden.

Alternativ sieht die Erfindung vor, dass die Montagehilfe drei relativ zueinander verschwenkbare Schenkel umfasst, wobei lediglich die äußeren zwei der Schenkel an ihren freien Enden jeweils ein Befestigungselement aufweisen, wobei die drei Schenkel trogförmig aufspannbar angeordnet sind.

Eine trogförmige Aufspannung der Montagehilfe bedingt - gleich wie eine V-förmige Aufspannung - eine effektive und stabile Variante, um das einzubauende Einschubelement abzustützen. Eine weitere bevorzugte Ausführungsform sieht vor, dass die Befestigungselemente an den Schenkeln der Montagehilfe nach außen gegen die Schienen, insbesondere Blechwinkel des Rahmengestells verspreizbar sind, wodurch eine Haltekraft ausgeübt wird, die eine Befestigung der Montagehilfe auch ohne zusätzliche Verbindungsmittel, wie z.B. Schrauben erlaubt. Zur Verspreizung kann beispielsweise ein weiterer Schenkel oder ein Abstandhalter vorgesehen sein, der sich von einem Befestigungselement zum anderen Befestigungselement erstreckt und mit Vorspannung zwischen den beiden Befestigungselementen positioniert bzw. eingespannt wird, um die Befestigungselemente gegen die Schienen des Rahmengestells zu drücken. Der weitere Schenkel kann vorzugsweise an einem der beiden Schenkel schwenkbar befestigt sein.

Alternativ wäre auch denkbar die Schenkel der Montagehilfe miteinander einstückig und aus Federstahl auszubilden, wobei die Befestigungselemente sich an den beiden Enden des Federstahlbandes befinden. Da Federstahl eine gewisse Biegsamkeit bedingt, ist bei dieser Ausführungsform kein gesondertes Gelenk vonnöten, da die Verstellung, nämlich Verbiegung des Federstahlbandes eine Halbkreisform der Montagehilfe bewirkt, wodurch eine ähnliche Auflagefläche für das Einschubelement zur Verfügung gestellt wird wie bei einer Ausführung mit zwei zu einer V-Form verschwenkbaren Schenkeln.

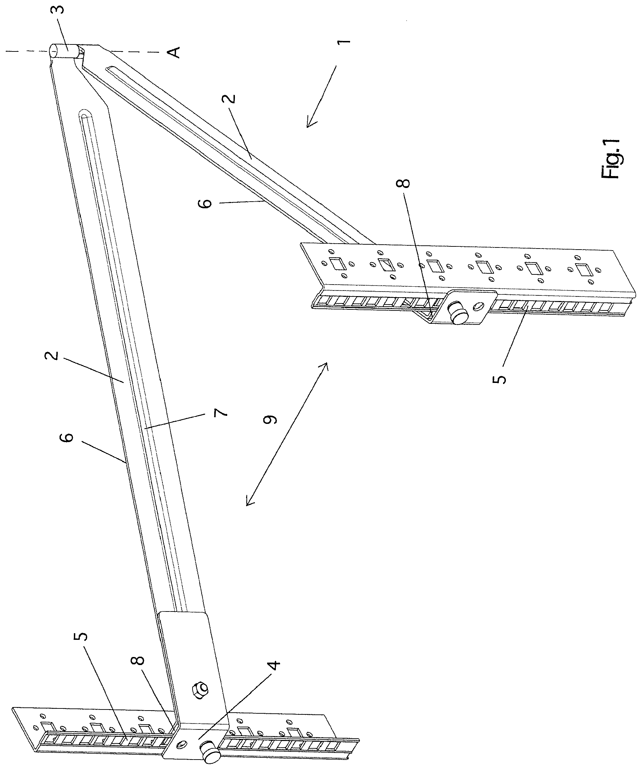

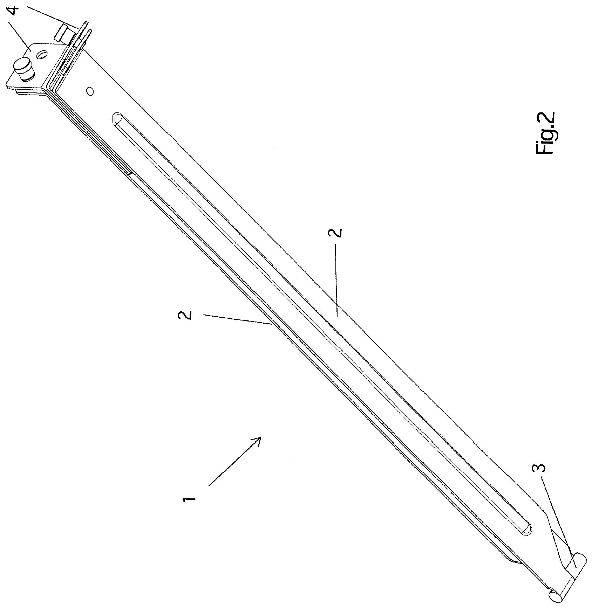

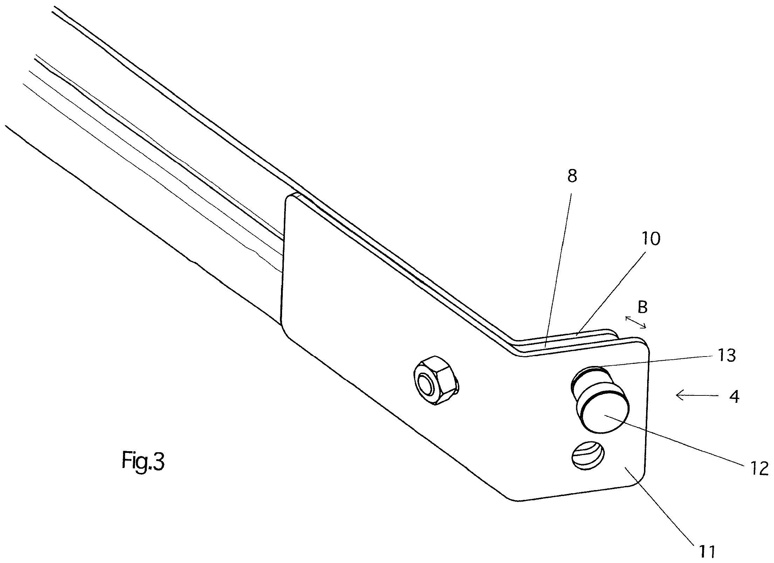

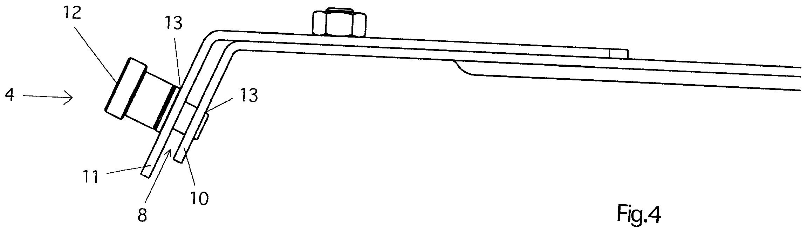

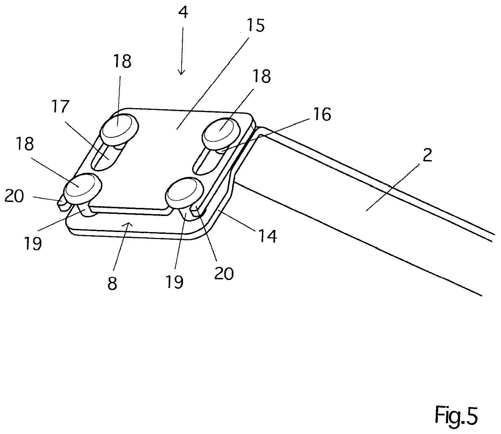

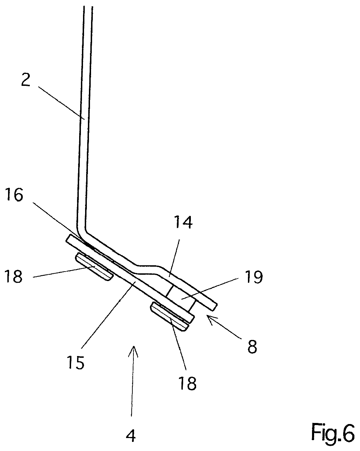

Die Erfindung wird nachfolgend anhand von in der Zeichnung schematisch dargestellten Ausführungsbeispielen näher erläutert. In dieser zeigen Fig. 1 eine perspektivische Ansicht einer Ausführungsform des erfindungsgemäßen Montageelements in der Montageposition, Fig. 2 eine perspektivische Ansicht der in Fig. 1 gezeigten Ausführungsform in der Aufbewahrungsposition, Fig. 3 eine perspektivische Detailansicht einer ersten Ausführungsform des abgewinkelt ausgebildeten Befestigungselements, Fig. 4 eine Draufsicht der in Fig. 3 dargestellten ersten Ausführungsform des abgewinkelt ausgebildeten Befestigungselements, Fig. 5 eine perspektivische Detailansicht einer zweiten Ausführungsform des abgewinkelt ausgebildeten Befestigungselements und Fig. 6 eine Draufsicht der in Fig. 5 gezeigten zweiten Ausführungsform des abgewinkelt ausgebildeten Befestigungselements.

In Fig. 1 ist eine Montagehilfe mit 1 bezeichnet. Die Montagehilfe 1 umfasst zwei relativ zueinander verschwenkbare Schenkel 2, welche durch ein eine Schwenkachse A aufweisendes Scharnier 3 unmittelbar miteinander verbunden sind. Die Schenkel 2 weisen an ihren freien Enden jeweils ein zum Schenkel 2 abgewinkelt angeordnetes Befestigungselement 4 auf, wobei die Schenkel 2 an zueinander gerichteten, nach innen ragenden und mit einer Lochreihe versehenen Blechwinkeln 5 eines Rahmengestells befestigt sind.

Fig. 1 zeigt die Montagehilfe 1 in der V-förmig um die Schwenkachse A des Scharniers 3 auseinander geklappten Montageposition. In dieser Position bildet die Oberkante 6 der Schenkel 2 eine Auflagefläche für ein einzubauendes Einschubelement (in Fig. 1 nicht dargestellt). Weiters besitzen die Schenkel 2 in Längsrichtung verlaufende Verstärkungsrippen 7, um die Biegesteifigkeit der Schenkel 2 zu erhöhen.

Zur Befestigung der Montagehilfe 1 an den Blechwinkeln 5 des Rahmengestells sind die Blechwinkel 5 jeweils in einem nach außen offenen Spalt 8 der Befestigungselemente 4 aufgenommen.

Wie aus Fig. 1 ersichtlich ist der Blechwinkel 5 des Rahmengestells mit einer Lochreihe versehen.

Im nicht an den Blechwinkeln 5 des Rahmengestells befestigten Zustand kann die Montagehilfe 1 entsprechend Pfeil 9 um die Schwenkachse A zusammen- bzw. auseinandergeklappt werden.

Fig. 2 zeigt eine perspektivische Ansicht des in Fig. 1 dargestellten Montageelements 1 in der zusammengeklappten Aufbewahrungsposition. Die Schenkel 2 liegen plan aneinander und sind nicht auseinanderverschwenkt. Lediglich die abgewinkelt angeordneten Befestigungselemente 4 am Ende der Schenkel 2 stehen ab.

In Fig. 3 ist gezeigt, dass der im Befestigungselement 4 ausgebildete Spalt 8 durch zwei parallele Platten 10, 11 gebildet wird. Die Platten 10, 11 sind in einem verstellbaren Abstand B voneinander gehalten und mit Hilfe eines Spannmittels 12 unter Einklemmung des in Fig. 3 nicht dargestellten Blechwinkels 5 zusammenspannbar bzw. an diese anpassbar.

Das Befestigungselement 4 greift am Blechwinkel 5 des Rahmengestells an, wobei der Spalt 8 den Blechwinkel 5 aufnimmt. Um das Montageelement 1 in der korrekten Position zu fixieren, wird der Spalt 8 den Blechwinkel 5 umschließend platziert und zwar derart, dass die in den Platten 10, 11 befindlichen Löcher die in der Lochleiste des Blechwinkels 5 befindlichen Löcher jeweils überdecken. Um den Abstand zwischen den Platten 10, 11 zu verringern und so ein Einklemmen des Blechwinkels 5 zwischen den Platten 10, 11 zu bedingen, wird das Spannmittel 12 durch das Loch 13 der Platte 11 gesteckt und dann in ein an der ersten Platte 10 ausgebildetes Gewindeloch 13 geschraubt (Fig. 4).

Fig. 4 zeigt eine Draufsicht der in Fig. 3 dargestellten ersten Ausführungsform des abgewinkelt ausgebildeten Befestigungselements 4.

Fig. 5 zeigt eine zweite Ausführungsform des abgewinkelt ausgebildeten Befestigungselements 4. Die erste, den Spalt 8 begrenzende Platte 14 ist hierbei starr mit dem Schenkel 2 verbunden und besitzt vier Bolzen 16 und 19. Zwei Bolzen 16 sind in Langlöchern 17 der zweiten Platte 15 geführt, sodass die zweite Platte 15 relativ zur ersten Platte verschieblich geführt ist. Dabei weisen die Bolzen 16 verdickte Enden 18 auf, welche den maximalen Abstand zwischen den beiden Platten 14, 15 bzw. die Dicke des Spaltes 8 definieren. Zwei weitere Bolzen 19 weisen ebenfalls verdickte Enden 18 auf, die in der in Fig. 5 dargestellten Verschiebeposition der zweiten Platte 15 Ränder von offenen Schlitzen 20 hintergreifen. Um das Befestigungselement 4 an einem Blechwinkel 5 zu befestigen, werden die durch Wegschieben der zweiten Platte 15 freigelegten Bolzen 18 durch korrespondiere Löcher des Blechwinkels 5 gesteckt, sodass die verdickten Enden 18 der Bolzen 19 auf der anderen Seite der Blechwinkel 5 vorragen. Danach wird die zweite Platte 15 relativ zur ersten Platte 14 verschoben bis die randseitig offenen Schlitze 20 die Bolzen 19 umgreifen, wobei die verdickten Enden 18 der Bolzen 19 den Rand des jeweiligen Schlitzes 20 hintergreifen, wodurch die Bolzen 19 gegen ein Herausfallen aus den Löchern des Blechwinkels 5 gesichert sind und das Befestigungselement 4 am Blechwinkel 5 fixiert ist.

Fig. 6 zeigt eine Draufsicht der in Fig. 5 gezeigten zweiten Ausführungsform des abgewinkelt ausgebildeten Befestigungselements 4.

## Patentansprüche

1. Montagehilfe (1) für die Montage von Einschubelementen in Rahmengestellen, insbesondere Racks für die Verwendung in der Informationstechnik, umfassend zumindest zwei relativ zueinander verstellbare, insbesondere verschwenkbare Schenkel (2), wobei die Schenkel (2) an ihren freien Enden jeweils ein zum Schenkel (2) abgewinkelt angeordnetes Befestigungselement (4) aufweisen, welche zum Befestigen der freien Enden der Schenkel (2) an zueinander gerichteten, nach innen ragenden und mit einer Lochreihe versehenen Schienen, insbesondere Blechwinkeln (5) des Rahmengestells ausgebildet sind, **dadurch gekennzeichnet, dass** die Schenkel (2) durch ein die Schwenkachse (A) aufweisendes Gelenk (3) unmittelbar miteinander verbunden sind oder dass die Montagehilfe (1) drei relativ zueinander verschwenkbare Schenkel umfasst, wobei lediglich die äußeren zwei der Schenkel an ihren freien Enden jeweils ein Befestigungselement aufweisen, wobei die drei Schenkel trogförmig aufspannbar angeordnet sind.

2. Montagehilfe nach Anspruch 1, **dadurch gekennzeichnet, dass** die Schenkel (2) zwischen einer aneinanderliegenden Aufbewahrungsposition und einer V-förmig auseinandergeklappten Montageposition verschwenkbar sind.

3. Montagehilfe nach Anspruch 1 oder 2, **dadurch gekennzeichnet, dass** das abgewinkelt ausgebildete Befestigungselement (4) einen Spalt (8) aufweist, in welchem die mit der Lochreihe versehene Schiene, insbesondere Blechwinkel (5) des Rahmengestells aufnehmbar ist.

4. Montagehilfe nach einem der Ansprüche 1 bis 3, **dadurch gekennzeichnet, dass** die Schenkel (2) um eine parallel zur Längserstreckung der Schienen, insbesondere Blechwinkel (5) verlaufende Schwenkachse (A) relativ zueinander verschwenkbar sind.

5. Montagehilfe nach einem der Ansprüche 1 bis 4, **dadurch gekennzeichnet, dass** der Spalt (8) durch zwei parallele Platten (10, 11; 14, 15) gebildet wird.

6. Montagehilfe nach Anspruch 5, **dadurch gekennzeichnet, dass** die Platten (10, 11) in verstellbarem Abstand (B) voneinander gehalten sind und mit Hilfe von Spannmitteln (12) unter Einklemmung der Schiene, insbesondere des Blechwinkels (5) zusammenspannbar sind.

7. Montagehilfe nach Anspruch 6, **dadurch gekennzeichnet, dass** die Spannmittel (12) Schrauben sind.

8. Montagehilfe nach einem der Ansprüche 5 bis 7, **dadurch gekennzeichnet, dass** eine erste der beiden Platten (14) starr mit dem jeweiligen Schenkel (2) verbunden ist und wenigstens ein, vorzugsweise zwei, durch ein Loch der Lochreihe steckbare(s) Verbindungselement(e) (16, 19) trägt, und dass eine zweite der beiden Platten (15) vom Verbindungselement (16, 19) hintergriffen werdend einschiebbar angeordnet ist.

9. Montagehilfe nach Anspruch 8, **dadurch gekennzeichnet, dass** die zweite Platte (15) relativ zur ersten Platte (14), vorzugsweise an dieser, verschiebbar geführt ist.

10. Montagehilfe nach Anspruch 8 oder 9, **dadurch gekennzeichnet, dass** die zweite Platte (15) wenigstens einen randseitig offenen Schlitz (20) aufweist, dessen Ränder in der zur Lochreihe hin verschobenen Position der zweiten Platte (15) von einem verbreiterten Ende (18) des Verbindungselements (19), insbesondere Stifts, hintergriffen sind.

11. Verwendung einer Montagehilfe nach einem der Ansprüche 1 bis 10 zur Montage an zueinander gerichteten, nach innen ragenden und mit einer Lochreihe versehenen Schienen, insbesondere Blechwinkeln (5) eines Rahmengestells, insbesondere Racks, wobei die Befestigungselemente (4) an den Schienen, insbesondere Blechwinkeln (5) befestigt werden und die Schenkel (2) eine Auflagefläche für an den Schienen, insbesondere Blechwinkeln (5) des Rahmengestells zu montierende Einschubelemente ausbilden.

## Claims

1. Mounting aid (1) for the mounting of rack mounts in framed, in particular racks for use in information technology, comprising at least two relatively to one another adjustable, in particular pivotable legs (2), wherein the legs (2) at their free ends each comprises a fastening element (4) that is arranged in an angled manner with respect to the leg (2) and is designed for fastening the free ends of the legs (2) to rails, in particular sheet metal angles (5), of the frame, said rails being directed to each other, projecting inwardly and being provided with a row of holes, **characterized in that** the legs (2) are directly interconnected by a hinge (3) comprising the pivot axis (A) or the mounting aid (1) comprises three legs pivotable relative to each other, wherein only the outer two of the legs each have a fastening element at their free ends, wherein the three legs are arranged to be swung open in a trough-shaped manner.

2. Mounting aid according to claim 1, **characterized in that** the legs (2) are pivotable between a storage position abutting against each other and a V-shaped unfolded mounting position.

3. Mounting aid according to claim 1 or 2, **characterized in that** the angled fastening element (4) has a gap (8) in which the rail, in particular the sheet metal angles (5), of the frame provided with the row of holes is receivable.

4. Mounting aid according to any one of claims 1 to 3, **characterized in that** the legs (2) are pivotable relative to one another about a pivot axis (A) extending parallel to the longitudinal extension of the rails, in particular sheet metal angles (5).

5. Mounting aid according to any one of claims 1 to 4, **characterized in that** the gap (8) is formed by two parallel plates (10, 11; 14, 15).

6. Mounting aid according to claim 5, **characterized in that** the plates (10, 11) are held at an adjustable distance (B) from each other and are capable of being clamped together with the aid of clamping means (12) while clamping the rail, in particular the sheet metal angle (5), in between.

7. Mounting aid according to claim 6, **characterized in that** the clamping means (12) are screws.

8. Mounting aid according to any one of claims 5 to 7, **characterized in that** a first of the two plates (14) is rigidly connected to the respective leg (2) and carries at least one, preferably two, connecting element(s) (16,19) being able to be put through a hole of the row of holes, and that a second of the two plates (15) is arranged to be insertable so as to be engaged from behind by the connecting element (16, 19) .

9. Mounting aid according to claim 8, **characterized in that** the second plate (15) is slidably guided relative to the first plate (14), preferably on the first plate (14).

10. Mounting aid according to claim 8 or 9, **characterized in that** the second plate (15) has at least one slot (20) open towards the edge of the plate, the edges of the slot being engaged from behind by a widened end (18) of the connecting element (19), in particular pin, when the second plate (15) is positioned to be displaced towards the row of holes.

11. Use of a mounting aid according to any one of claims 1 to 10 for mounting on rails, in particular sheet metal angles (5), of a frame, in particular a rack, said rails being directed to each other, projecting inwardly and being provided with a row of holes, wherein the fastening elements (4) are fixed on the rails, in particular sheet metal angles (5), and the legs (2) form a bearing surface for rack mounts to be mounted on the rails, in particular sheet metal angles (5), of the frame.

## Revendications

1. Aide au montage (1) pour le montage d'éléments rackables dans des châssis, en particulier des racks destinés à être utilisés dans les technologies de l'information, comprenant au moins deux branches (2) réglables, en particulier pivotables, l'une par rapport à l'autre, dans laquelle les branches (2) présentent respectivement à leurs extrémités libres un élément de fixation (4) disposé angulairement par rapport à la branche (2), lesquelles sont réalisées pour fixer les extrémités libres des branches (2) sur des rails dirigés les uns vers les autres, faisant saillie vers l'intérieur et pourvus d'une rangée de trous, en particulier des équerres de tôle (5) du châssis, **caractérisée en ce que** les branches (2) sont reliées directement entre elles par une articulation (3) présentant l'axe de pivotement (A), ou **en ce que** l'aide au montage (1) comprend trois branches pivotables les unes par rapport aux autres, dans laquelle seules les deux extérieures parmi les branches présentent respectivement un élément de fixation à leurs extrémités libres, dans laquelle les trois branches sont disposées de manière à pouvoir être serrées en forme d'auge.

2. Aide au montage selon la revendication 1, **caractérisée en ce que** les branches (2) sont pivotables entre une position de rangement en appui les unes contre les autres et une position de montage déployée en forme de V.

3. Aide au montage selon la revendication 1 ou 2, **caractérisée en ce que** l'élément de fixation (4) réalisé angulairement présente une fente (8), dans laquelle le rail pourvu de la rangée de trous, en particulier l'équerre de tôle (5) du châssis, peut être reçu.

4. Aide au montage selon l'une quelconque des revendications 1 à 3, **caractérisée en ce que** les branches (2) sont pivotables les unes par rapport aux autres autour d'un axe de pivotement (A) s'étendant parallèlement à l'extension longitudinale des rails, en particulier des équerres de tôle (5).

5. Aide au montage selon l'une quelconque des revendications 1 à 4, **caractérisée en ce que** la fente (8) est formée par deux plaques parallèles (10, 11; 14, 15).

6. Aide au montage selon la revendication 5, **caractérisée en ce que** les plaques (10, 11) sont maintenues à un écart réglable (B) les unes des autres et peuvent être serrées ensemble à l'aide de moyens de serrage (12) lors du pincement du rail, en particulier de l'équerre de tôle (5).

7. Aide au montage selon la revendication 6, **caractérisée en ce que** les moyens de serrage (12) sont des vis.

8. Aide au montage selon l'une quelconque des revendications 5 à 7, **caractérisée en ce qu'**une première des deux plaques (14) est connectée de manière rigide à la branche respective (2) et porte au moins un, de préférence deux, élément(s) de connexion (16, 19) enfichable(s) à travers un trou de la rangée de trous, et **en ce qu'**une seconde des deux plaques (15) est disposée de manière insérable de sorte que l'élément de connexion (16, 19) devienne enclenché.

9. Aide au montage selon la revendication 8, **caractérisée en ce que** la seconde plaque (15) est guidée de manière déplaçable par rapport à la première plaque (14), de préférence sur cette dernière.

10. Aide au montage selon la revendication 8 ou 9, **caractérisée en ce que** la seconde plaque (15) présente au moins une fente (20) ouverte du côté du bord, dont les bords sont enclenchés par une extrémité élargie (18) de l'élément de connexion (19), en particulier un goujon, dans la position de la seconde plaque (15) décalée vers la rangée de trous.

11. Utilisation d'une aide au montage selon l'une quelconque des revendications 1 à 10 pour le montage sur des rails, en particulier des équerres de tôle (5) d'un châssis, en particulier des racks, dirigés les uns vers les autres, faisant saillie vers l'intérieur et pourvus d'une rangée de trous, dans laquelle les éléments de fixation (4) sont fixés aux rails, en particulier aux équerres de tôle (5), et les branches (2) réalisent une surface de contact pour des éléments rackables à monter sur les rails, en particulier les équerres de tôle (5) du châssis.
